# FASCICULE DE BREVET EUROPEEN

(11) **EP 3 333 920 B1**
(45) Date de publication et mention de la délivrance du brevet: **25.01.2023**
(21) Numéro de dépôt: 17205118.7
(22) Date de dépôt: 04.12.2017
(51) Int. Cl.: H01L 51/44, H01G 9/20

(54) **CELLULE PHOTOVOLTAÏQUE POURVUE D'UNE COUCHE N COMPOSITE**
FOTOVOLTAIKZELLE, DIE MIT EINER N-VERBUNDSCHICHT VERSEHEN IST
PHOTOVOLTAIC CELL PROVIDED WITH A COMPOSITE N-LAYER

(30) Priorité: 12.12.2016 FR 1662285
(43) Date de publication de la demande: 13.06.2018
(73) Titulaire: Commissariat à l'Energie Atomique et aux Energies Alternatives, 75015 Paris (FR)
(72) Inventeur: MANCEAU, Matthieu, 73000 CHAMBERY (FR)
(74) Mandataire: Cabinet Laurent & Charras

(56) Documents cités:
- EP-A1- 1 385 182
- WO-A2-2011/050953
- QILIANG WU, WEIRAN ZHOU, QING LIU, PENGCHENG ZHOU, TAO CHEN, YALIN LU, QIQUAN QIAO,AND SHANGFENG YANG: "Solution-Processable Ionic Liquid as an Independent or ModifyingElectron Transport Layer for High-Efficiency Perovskite Solar Cells", ACS APPL. MATER. INTERFACES, vol. 8, 28 novembre 2016 (2016-11-28), pages 34464-34473, XP002772877, DOI: 10.1021/acsami.6b12683

## Description

### DOMAINE DE L'INVENTION

La présente invention concerne une cellule photovoltaïque contenant une couche semi-conductrice transporteuse d'électrons, également appelée ETL (pour l'acronyme anglo-saxon « Electron Transport Layer ») ou encore « couche N », composite à base de matériau organique et de matériau inorganique.

Le domaine d'utilisation de la présente invention concerne notamment la conversion d'énergie solaire en énergie électrique.

### ETAT ANTERIEUR DE LA TECHNIQUE

Une cellule photovoltaïque organique ou à matériau pérovskite est généralement constituée d'un empilement de couches sur un substrat, qui peut être transparent ou opaque. Il peut s'agir d'un empilement ayant une structure dite NIP comprenant au moins :
- un substrat, par exemple en PET,
- une première électrode ou électrode inférieure,
- une couche semi-conductrice transporteuse d'électrons, également appelée ETL (pour l'acronyme anglo-saxon « Electron Transport Layer ») ou encore « couche N »,
- une couche active (CA) en matériau semi-conducteur, organique ou pérovskite,
- une couche semi-conductrice, transporteuse de trous, également appelée HTL (pour l'acronyme anglo-saxon « Hole Transport Layer ») ou encore « couche P »,
- une deuxième électrode ou électrode supérieure.

Dans d'autres cas, l'empilement des couches peut varier afin d'obtenir une structure PIN : substrat/première électrode ou électrode inférieure/couche P/couche active/couche N/deuxième électrode ou électrode supérieure.

Par ailleurs, dans les deux cas, au moins l'une des deux électrodes est une couche conductrice transparente, par exemple en oxyde transparent conducteur (TCO). Si le substrat est transparent, il s'agit en général de la première électrode en contact avec le substrat. La deuxième électrode est alors une couche conductrice, en particulier en argent.

Les cellules photovoltaïques à base de pérovskite ayant une structure de type NIP présentent généralement de meilleurs rendements en termes de conversion des photons incidents en électrons, notamment lorsque la couche N est constituée d'un oxyde de titane sous forme mésoporeuse.

Cependant, les couches N en oxyde de titane sous forme mésoporeuse présentent l'inconvénient de devoir être fabriquées à une température supérieure à 400°C, ce qui rend l'utilisation de certains substrats comme le PET (poly(téréphtalate d'éthylène)) impossible.

Les alternatives à ce type de couche N en oxyde de titane sous forme mésoporeuse incluent les oxydes métalliques sous forme de couche dense, par exemple TiO₂, ZnO.... Les performances atteintes avec ces couches dites denses demeurent pour le moment inférieures à celles de dispositifs intégrant des couches mésoporeuses. Quant à la nature de l'oxyde, elle influence bien évidemment les performances finales du dispositif, mais également la cinétique de cristallisation de la pérovskite. QILIANG WU ("Solution-Processable Ionic Liquid as an Independent or ModifyingElectron Transport Layer for High-Efficiency Perovskite Solar Cells", ACS APPL. MATER. INTERFACES, vol. 8, 28-11-2016, pages 34464-34473) décrit une cellule photovoltaïque organique avec pérovskites et couche de TiO2 imprégnée de liquides ioniques.

Quand bien même les technologies de l'art antérieur permettent d'atteindre des rendements convenables, il existe un besoin d'améliorer non seulement les propriétés des cellules photovoltaïques, mais aussi leurs procédés de fabrication.

La présente invention permet de remédier à ces problèmes grâce à la présence d'un sel ionique aussi appelé « liquide ionique à l'état solide » dans la couche N dont la formation est compatible avec de nombreux substrats. La présente invention permet d'améliorer le transfert des charges à l'interface couche active/couche N, et ce quel que soit le type de cellule : organique ou pérovskite.

### EXPOSE DE L'INVENTION

La présente invention concerne une cellule photovoltaïque, en particulier une cellule photovoltaïque organique ou à matériau pérovskite, contenant une couche N composite, c'est-à-dire une couche N contenant au moins un matériau organique et au moins un matériau inorganique.

La présence de cette couche composite permet d'améliorer les performances de la cellule photovoltaïque, notamment le rendement de conversion photovoltaïque.

Plus précisément, la présente invention concerne une cellule photovoltaïque comprenant successivement une couche N, une couche active et une couche P, la couche N comprenant des particules d'oxyde métallique (np) et au moins un composé pyridinium (Pyr-X) de formule C₅H₄R₁NR₂⁺X⁻ : 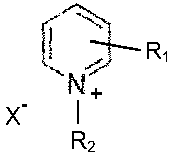
R₁ et R₂ étant indépendamment l'un de l'autre un groupement hydrocarboné en C₁-C₈, X⁻ étant un anion,
la couche N présentant un rapport massique np/Pyr-X compris entre 97/3 et 75/25.

La couche N est avantageusement constituée des particules d'oxyde métallique (np) et de Pyr-X. De manière encore plus avantageuse, elle est constituée d'un seul type de particules np et d'un seul type de composé pyridinium Pyr-X.

Le composé pyridinium Pyr-X est un liquide ionique constitué du cation pyridinium et de l'anion X⁻.

L'anion X⁻ est avantageusement un halogène, par exemple un iodure ou un chlorure.

Les groupements R₁ et R₂ du pyridinium Pyr-X sont des groupements hydrocarbonés, avantageusement dépourvus d'atomes autres que le carbone ou l'hydrogène. Ils peuvent comprendre des ramifications et/ou des groupements cycliques.

Ainsi, il peut s'agir de groupements alkyles linéaires ou ramifiés, ou de groupements cycliques, ou de chaines hydrocarbonées contenant des groupements cycliques. R₁ et R₂ sont avantageusement des groupements alkyles linéaires en C₁-C₈ distincts l'un de l'autre.

De manière avantageuse, les groupements R₁ et sont tous les deux des groupements alkyles linéaires constitués d'au maximum 4 atomes de carbone.

Alors que le groupement R₂ est positionné sur l'atome d'azote, le groupement R₁ est avantageusement positionné en position 4, c'est-à-dire en position *para* par rapport à l'atome d'azote du pyridinium. Aussi, Pyr est avantageusement le 1-butyl-4-méthylpyridinium.

Comme déjà indiqué, la couche N comprend avantageusement un seul composé pyridinium Pyr-X.

Outre le composé Pry-X, la couche N comprend également des particules d'oxyde métallique np.

La couche N présente un rapport massique np/Pyr-X avantageusement compris entre 90/10 et 80/20, plus avantageusement entre 90/10 et 85/15, et encore plus avantageusement entre 90/10 et 87/13.

Les particules d'oxyde métallique np sont avantageusement des nanoparticules. Leur taille est avantageusement comprise entre 2 et 100 nanomètres, plus avantageusement entre 5 et 50 nanomètres.

Par taille, on entend la dimension la plus importante des particules, par exemple le diamètre pour des particules sphériques.

Il peut notamment s'agir de particules d'oxyde d'un métal choisi dans le groupe comprenant le zinc ; le titane ; l'indium ; l'étain ; et leurs mélanges.

Ces oxydes peuvent être dopés, par exemple avec un métal. A titre d'exemple, les particules peuvent être choisies dans le groupe comprenant les particules d'oxyde de zinc dopé à l'aluminium (AZO), d'oxyde de zinc dopé au gallium (GZO), d'oxyde d'indium dopé au zinc (ZTO), d'oxyde de titane dopé au zinc, d'oxyde de titane dopé au fluor, d'oxyde de titane dopé à l'indium, d'oxyde d'étain dopé à l'aluminium, d'oxyde d'étain dopé au fluor, d'oxyde d'étain dopé au cuivre, et leurs mélanges.

Comme déjà indiqué, la couche N comprend avantageusement un seul type de particules d'oxyde métallique np.

Selon un mode de réalisation particulier, la couche N peut comprendre, outre Pyr-X et les particules d'oxyde métallique np, au moins un additif choisi dans le groupe comprenant les agents compatibilisant, par exemple un tensioactif ; les agents de mouillabilité ; et les agents dispersants.

Un agent compatibilisant permet d'améliorer la compatibilité entre les particules d'oxyde métallique np et le composé pyridinium Pyr-X.

De manière générale, les éléments constitutifs de la cellule photovoltaïque comporte au moins :
- un substrat,
- une première électrode, par exemple formée par un oxyde transparent conducteur,
- une couche N,
- une couche active,
- une couche P,
- et une deuxième électrode, par exemple en argent.

Il s'agit généralement d'un empilement de couches.

La cellule photovoltaïque selon l'invention n'est pas limitée à ce nombre de couches. Il peut notamment s'agir d'une cellule photovoltaïque tandem associant un empilement NIP ou PIN avec une couche active en matériau semi-conducteur. Une cellule tandem est généralement formée par des mélanges de matériaux organiques ou par un matériau pérovskite, avec un empilement à base de silicium et notamment une cellule à hétérojonction silicium cristallin/silicium amorphe.

La cellule photovoltaïque selon l'invention peut ainsi être une cellule de type PIN ou de type NIP.

Il s'agit avantageusement d'une cellule NIP. Dans ce cas, la cellule photovoltaïque comprend au moins successivement :
- un substrat,
- une première électrode, par exemple une couche transparente conductrice, notamment une couche en oxyde transparent conducteur,
- une couche N composite,
- une couche électriquement active (CA) également appelée couche active,
- une couche P, et
- une deuxième électrode, par exemple en argent.

Une structure PIN comprend l'empilement substrat/couche transparente conductrice/couche P/couche active/couche N composite/électrode.

Le substrat peut être en un matériau choisi dans le groupe comprenant le verre ; le PET (poly(téréphtalate d'éthylène) ; et le PEN (poly(naphtalate d'éthylène). Le substrat peut être transparent (laisse passer la lumière) ou opaque (ne laisse pas passer la lumière).

Le substrat présente une épaisseur avantageusement comprise entre 25 micromètres et 2,2 millimètres, plus avantageusement entre 100 et 1100 micromètres.

La première électrode de la cellule photovoltaïque peut être en un matériau choisi dans le groupe comprenant les oxydes transparents conducteurs ; les nanofils d'argent ; un assemblage d'un polymère conducteur (par exemple le PEDOT:PSS) et d'une grille métallique (par exemple en argent).

La première électrode présente une épaisseur avantageusement comprise entre 20 nm et 2 µm, plus avantageusement entre 100 nm et 500 nm.

Lors du fonctionnement de la cellule photovoltaïque, la première électrode joue plus précisément le rôle de cathode dans le cas de la structure NIP. Respectivement elle joue le rôle d'anode dans le cas de la structure PIN.

La couche N composite présente une épaisseur avantageusement comprise entre 5 et 200 nanomètres, plus avantageusement entre 10 et 100 nanomètres.

La couche N présente une composition avantageusement homogène et dense. La couche N est avantageusement non mésoporeuse. Elle peut être réalisée selon les techniques conventionnelles. En effet, son intégration dans la cellule photovoltaïque ne nécessite pas de modifier les procédés conventionnels.

La couche active (CA) comporte un ou des matériaux semi-conducteurs. Il peut s'agir d'un ou plusieurs matériaux semi-conducteur(s) organique(s) (cellule organique simple jonction ou tandem) ou d'au moins un matériau pérovskite (cellule à base de pérovskite simple jonction ou tandem).

La couche électriquement active (CA) peut être organique ou à base de pérovskite.

Ainsi, la cellule photovoltaïque selon l'invention peut être :
- une cellule photovoltaïque organique, ou
- une cellule photovoltaïque tandem comprenant une cellule photovoltaïque organique et une cellule photovoltaïque à hétérojonction de silicium, ou
- une cellule photovoltaïque à base de pérovskite, ou
- une cellule photovoltaïque tandem comprenant une cellule photovoltaïque à base de pérovskite et une cellule photovoltaïque à hétérojonction de silicium.

Dans le cas d'une cellule photovoltaïque organique (OPV), la couche active comprend généralement un mélange contenant au moins deux matériaux semi-conducteurs : un matériau semi-conducteur organique de type N, accepteur d'électrons, et un matériau semi-conducteur organique de type P, donneur d'électrons.

Le matériau semi-conducteur de type P contenu dans la couche active peut être choisi parmi les polymères contenant des motifs thiophènes, les polymères contenant des motifs thiénothiophènes, les polymères contenant des motifs diketopyrrolopyrroles, les polymères contenant des motifs benzothiadiazoles, les polymères contenant des motifs thienopyrrolediones, les polymères contenant des motifs bithiophenedicarboximides et les polymères contenant des motifs carbazoles.

Par exemple, le polymère semi-conducteur de type P dans une couche active peut être choisi parmi les polymères suivants : le (poly(3-hexylthiophène) ou P3HT, le poly[N-9'-heptadecanyl-2,7-carbazole-alt-5,5-(4,7-di-2-thienyl-2',1',3'-benzothiadiazole ou PCDTBT, le poly[2,1,3-benzothiadiazole-4,7-diyl[4,4-bis(2-ethylhexyl)-4H-cyclo penta[2,1-b:3,4-b']dithiophene-2,6-diyl]] ou PCPDTBT, le poly[[5-(2-ethylhexyl)-5,6-dihydro-4,6-dioxo-4H-thieno[3,4-c]pyrrole-1,3-diyl][4,8-bis[(2-ethylhexyl)oxy]benzo [1,2-b:4,5-b']dithiophene-2,6-diyl]] ou PBDTTPD, le poly[[4,8-bis[(2-ethylhexyl)oxy] benzo [1,2-b:4,5-b']dithiophene-2,6-diyl][3-fluoro-2-[(2-ethylhexyl) carbonyl]thieno [3,4-b]thiophenediyl]] ou PTB7.

Le matériau semi-conducteur de type P contenu dans une couche active peut également être choisi parmi les molécules semi-conductrices de type P telles que :
- la porphyrine,
- 7,7'-(4,4-bis(2-ethylhexyl)-4H-silolo[3,2-b:4,5-b 2]dithiophene-2,6-diyl)bis(6-fluoro-4-(5 '-hexyl-[2,2'-bithiophen]-5-yl)benzo[c][1 ,2,5]thiadiazole) : p-DTS(FBTTh₂)₂,
- les bore-dipyrométhènes (BODIPY),
- les molécules à noyau triphénylamine (TPA).

Le matériau semi-conducteur de type N contenu dans la couche active est avantageusement un matériau carboné choisi parmi les matériaux contenant au moins un motif parmi :
- pérylènes,
- fullerènes, par exemple le fullerène C₆₀, le fullerène C₇₀, le fullerène C₈₀ ou le fullerène C₈₄,
- les nano- tubes de carbone semi-conducteurs,
- le graphène et les nanographènes,
- et leurs dérivés solubles, tels que le [6,6]-phényl-C₆₁-butyrate de méthyle également connu sous le nom PCBM ou PC₆₁BM, le [6,6]-phényl-C₇₁-butyrate de méthyle ou PC₇₁BM, un thiophène-C₆₁-butyrate de méthyle, un multi-adduit d'un fullerène C₆₀ ou C₇₀ ou des nanotubes de carbone fonctionnalisés,
- des polymères de type N.

De préférence, le matériau semi-conducteur de type N est choisi parmi les matériaux contenant des motifs fullérènes notamment C₆₀, C₇₀, C₈₀ et C₈₄, les matériaux contenant des motifs pérylènes, en particulier les matériaux suivants PC₆₀BM et PC₇₀BM.

A titre d'exemple, la couche active peut être constituée d'un mélange de P3HT et de PCBM.

Dans le cas d'une cellule photovoltaïque à matériau pérovskite, la couche active comporte au moins un matériau pérovskite hybride organique-inorganique, comme par exemple ceux de la formulation AMeX3 dans laquelle :
- A représente au moins un ion organo-ammonium par exemple de type méthylamonium (MA) ou bien formamidinium (FA) ou bien un mélange des deux, éventuellement associé à du césium et/ou du rubidium,
- Me représente au moins un métal parmi le plomb, l'étain, le bismuth et l'antimoine, et
- X est choisi parmi : Cl, Br, I ou une combinaison de ces halogénures.

Il peut notamment s'agir d'un matériau pérovskite hybride à base de plomb.

A titre d'exemple, le matériau de la couche active peut notamment être CH₃NH₃PbI₃₋ₓClₓ avec x compris entre 0 et 10 ou CH₃NH₃PbI₃₋ₓBrₓ avec x compris entre 0 et 100.

La couche active présente une épaisseur avantageusement comprise entre 100 et 1000 nanomètres, plus avantageusement entre 150 et 500 nanomètres.

De manière générale, la couche P peut être en un matériau choisi dans le groupe comprenant des polymères conjugués semi-conducteurs de type P et notamment le P3HT (poly(3-hexylthiophène)) ; des polymères conducteurs et notamment le PEDOT:PSS ; des oxydes métalliques de type P et notamment WO₃, V₂O₅ et NiO.

La couche P présente une épaisseur avantageusement comprise entre 25 nanomètres et 1 micromètre, plus avantageusement entre 50 et 500 nanomètres.

La deuxième électrode peut être en un matériau choisi dans le groupe comprenant l'or, l'argent et l'aluminium.

Elle présente une épaisseur avantageusement comprise entre 25 et 2500 nanomètres, plus avantageusement entre 50 et 200 nanomètres.

Lors du fonctionnement de la cellule photovoltaïque, cette électrode joue le rôle d'anode dans une cellule NIP. Respectivement elle joue le rôle de cathode dans le cas de la structure PIN.

La présence du Pyr-X permet d'améliorer le transfert des charges à l'interface entre la couche N et la couche active et, ce sans altérer la cinétique de cristallisation de la couche active lorsque la couche active est à base de pérovskite.

La présente invention concerne également un procédé de préparation d'une couche N.

La couche N est avantageusement formée en voie solvant, à partir d'une encre correspondant à une dispersion comprenant des particules d'au moins un oxyde métallique (np) et au moins un composé pyridinium (Pyr-X) dans un solvant.

Selon un mode de réalisation particulier, la préparation de la couche N comprend les étapes suivantes :
- préparation d'une encre pour une couche N, comprenant au moins un solvant, des particules d'oxyde métallique (np) et au moins un composé pyridinium (Pyr-X) de formule C₅H₄R₁NR₂⁺X⁻ : 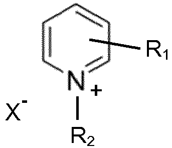
   R₁ et R₂ étant indépendamment l'un de l'autre un groupement hydrocarboné en C₁-C₈,
   X⁻ étant un anion,
   l'encre présentant un rapport massique np/Pyr-X compris entre 97/3 et 75/25,
- dépôt de l'encre de couche N sur un substrat,
- élimination du solvant de l'encre déposée,
- formation d'une couche N.

L'invention concerne en outre un procédé de préparation d'une cellule photovoltaïque ayant une structure NIP, selon les étapes suivantes :
- formation d'une première électrode sur un substrat,
- formation d'une couche N, sur la première électrode, par :
   * préparation d'une encre pour couche N comprenant au moins un solvant, des particules d'oxyde métallique (np) et au moins un composé pyridinium (Pyr-X) de formule C₅H₄R₁NR₂⁺X⁻ : 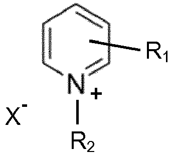
      R₁ et R₂ étant indépendamment l'un de l'autre un groupement hydrocarboné en C₁-C₈,
      X⁻ étant un anion,
      l'encre présentant un rapport massique np/Pyr-X compris entre 97/3 et 75/25,
   * dépôt de l'encre pour couche N sur la première électrode,
   * élimination du solvant de l'encre déposée,
- formation d'une couche active sur la couche N,
- formation d'une couche P sur la couche active,
- formation d'une deuxième électrode sur la couche P.

La nature de la couche N permet un dépôt uniforme et homogène, notamment sur une couche transparente conductrice.

Le procédé de préparation d'une cellule photovoltaïque ayant une structure PIN fait également partie de l'invention. Il comprend les étapes suivantes :
- formation d'une couche transparente conductrice sur un substrat,
- formation d'une couche P sur la couche transparente conductrice,
- formation d'une couche active sur la couche P,
- formation d'une couche N sur la couche active, conformément au mode opératoire ci-dessus :
- formation d'une électrode sur la couche N.

Les caractéristiques (matériaux, épaisseur...) relatives aux différentes couches sont indiquées ci-dessus.

L'encre de couche N peut être déposée par les techniques conventionnelles, par exemple par enduction centrifuge (« *spin-coating* »). D'autres techniques de dépôt incluent l'enduction par filière en forme de fente (*« slot-die coating »*), l'impression jet d'encre, la sérigraphie (rotative ou à plat), l'héliogravure, la flexographie et le couchage barre (*« bar-coating »*)*.*

Le solvant de l'encre de couche N peut notamment être choisi dans le groupe comprenant un alcool, par exemple l'isopropanol ou l'éthanol ; un éther de glycol (par exemple l'éthylène glycol monobutyl éther); un diol (par exemple l'éthylène glycol) ; et leurs mélanges.

L'élimination du solvant est également réalisée de manière conventionnelle, par exemple par séchage thermique ou par évaporation sous vide.

Comme déjà indiqué, la cellule photovoltaïque selon l'invention peut être une cellule « simple jonction » ou une cellule tandem par exemple en combinaison avec le silicium.

La couche N décrite ci-dessus peut également être utilisée dans un photodétecteur.

L'invention et les avantages qui en découlent ressortiront mieux des exemples suivants donnés de manière non limitative afin d'illustrer l'invention.

### EXEMPLES DE REALISATION DE L'INVENTION

Plusieurs cellules photovoltaïques ont été préparées et testées pour mettre en évidence les avantages que procure la présence d'un composé pyridinium (Pyr-X) de formule C₅H₄R₁NR₂⁺X⁻.

Ces cellules, de type NIP, comprennent l'empilement suivant :
- un substrat en verre,
- une couche conductrice en oxyde métallique,
- une couche N,
- une couche active en pérovskite CH₃NH₃Pbl₃₋ₓClₓ (x < 5),
- une couche P en P3HT (poly(3-hexylthiophène)),
- une électrode en or.

Les trois premières couches (couche N, couche active et couche P) ont été réalisées par enduction centrifuge (« *spin-coating* ») alors que l'électrode en or a été déposée par évaporation sous vide.

La couche N a été préparée à partir d'une dispersion de nanoparticules d'oxyde zinc dopé à l'aluminium (AZO), éventuellement en présence d'iodure de 1-butyl-4-méthylpyridinium.

A titre d'exemple, une encre a été préparée dans l'isopropanol à partir de :
- 2,5% en masse d'AZO (diamètre particules < 20 nanomètres)
- 0.3% en masse d'iodure de 1-butyl-4-méthylpyridinium.

La couche N résultant du dépôt et du séchage de cette encre contient 89.3% en masse d'AZO et 10.7 % en masse d'iodure de 1-butyl-4-méthylpyridinium.

La surface active des dispositifs ainsi préparés est de 0,28 cm².

Leurs performances ont été mesurées à 25°C dans des conditions standards d'éclairement (1000 W/m², AM 1.5G).

La préparation des cellules ainsi que leurs tests ont été réalisés en boîte à gants, sous atmosphère inerte.

Les données expérimentales relatives aux exemples selon l'invention (INV), dont la couche N comprend du Pyr-X, et les contre-exemples (CE), dont la couche N est uniquement à base de nanoparticules d'AZO, sont reproduites dans le tableau 1.

**Tableau 1 : Performances des cellules photovoltaïques en fonction de la quantité d'additif Pyr-X au sein de la couche N**

| Exemple | Couche N | | Voc (mV) | Jsc (mA/cm²) | FF (%) | PCE (%) |
|---|---|---|---|---|---|---|
| | AZO | Pyr-I | | | | |
| CE-1 | 100 | 0 | 952±15 | 20,9±0,6 | 54,2±2,2 | 10,8±0,6 |
| INV-1 | 89,3 | 10,7 | 949±2 | 20,6±1,0 | 61,2±2,1 | 12,0±0,8 |
| INV-2 | 85,7 | 14,3 | 940±1 | 21,0±0,9 | 62,2±1,9 | 12,3 |
| INV-3 | 78,6 | 21,4 | 933±3 | 19,7±0,8 | 61,7±3,1 | 11,3±0,7 |
| CE-2 | 67,9 | 32,1 | 938±7 | 19,0±1,1 | 56,3±0,3 | 10,0±0,6 |

| | | | | | | |
|---|---|---|---|---|---|---|
| Pyr-I : iodure de 1-butyl-4-méthylpyridinium CE : contre-exemple INV : exemple selon l'invention Voc : tension de circuit ouvert (aucun courant ne circule à travers la cellule) Jsc : densité de courant en court-circuit FF : facteur de forme PCE : rendement de conversion photovoltaïque | | | | | | |

Dans le tableau 1, la composition de la couche N (AZO + Pyr-I) est indiquée en pourcentage massique par rapport à la masse de la couche N.

Les résultats consignés dans le tableau 1 montrent que l'ajout de Pyr-I (iodure de 1-butyl-4-méthylpyridinium) provoque une augmentation significative du rendement (PCE) des cellules photovoltaïques selon l'invention (INV-1 à INV-3) en connexion avec l'augmentation du facteur de forme (FF) des cellules (venant elle-même d'une diminution de la résistance série).

Les performances optimales sont obtenues pour les exemples INV-1 et INV-3 par rapport au contre-exemple CE-1, dont la couche N ne contient pas de pyridinium. Au-delà d'une quantité de pyridinium seuil, le rendement des cellules décroît plus fortement (CE-2).

Comme déjà indiqué, l'augmentation des performances est notamment liée à une augmentation du facteur de forme (FF) des cellules *via* une diminution de la résistance série des dispositifs. Cette amélioration de la résistance série est elle-même liée aux propriétés du pyridinium utilisé, à savoir une bonne conductivité électrique et une bonne mobilité des porteurs de charges.

Outre l'iodure de 1-butyl-4-méthylpyridinium (INV-1 à INV-3), les composés suivants ont également été évalués :
- chlorure de 1-benzyl-3-méthylimidazolium,
- iodure de 1-butyl-3-méthylimidazolium,
- iodure de 2-chloro-1-méthylpyridinium,
- chlorure de 1-butyl-4-méthylpyridinium (INV-4 et INV-5).

Parmi ces composés, le chlorure de 1-butyl-4-méthylpyridinium (Pyr-Cl) permet également d'améliorer les performances de la cellule (INV-4 et INV-5 ; tableau 2). En revanche, les autres composés n'apportent pas d'avantage significatif.

Ces essais montrent les avantages liés à l'utilisation d'un pyridinium par rapport à un imidazolium. Ils montrent également que le substituant sur le cycle du pyridinium ne peut pas être un halogène.

**Tableau 2 : Performances des cellules photovoltaïques en fonction de la quantité d'additif Pyr-X au sein de la couche N**

| Exemple | Couche N | | Voc (mV) | Jsc (mA/cm²) | FF (%) | PCE (%) |
|---|---|---|---|---|---|---|
| | AZO | Pyr-Cl | | | | |
| CE-3 | 100 | 0 | 910±34 | 18,8±1,0 | 55,1±1,4 | 9,4±0,6 |
| INV-4 | 89,3 | 10,7 | 916±12 | 19,9±1,6 | 57,9±0,5 | 10,5±0,8 |
| INV-5 | 78,6 | 21,4 | 843±5 | 18,9±1,2 | 60,9±4,8 | 9,7±0,3 |

| | | | | | | |
|---|---|---|---|---|---|---|
| Pyr-Cl : chlorure de 1-butyl-4-méthylpyridinium | | | | | | |

## Revendications

1. Cellule photovoltaïque comprenant successivement une couche N, une couche active et une couche P,
la couche N comprenant des particules d'oxyde métallique (np) et au moins un composé pyridinium (Pyr-X) de formule C₅H₄R₁NR₂⁺X⁻ : 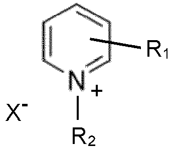
R₁ et R₂ étant indépendamment l'un de l'autre un groupement hydrocarboné en C₁-C₈,
X⁻ étant un anion,
la couche N présentant un rapport massique np/Pyr-X compris entre 97/3 et 75/25.

2. Cellule photovoltaïque selon la revendication 1, ***caractérisée* en ce que** l'anion X⁻ est un halogène,
et **en ce que** R₁ et R₂ sont des groupements alkyles linéaires en C₁-C₈ distincts l'un de l'autre.

3. Cellule photovoltaïque selon la revendication 1 ou 2, ***caractérisée* en ce que** la couche N présente un rapport massique np/Pyr-X compris entre 90/10 et 80/20, avantageusement entre 90/10 et 85/15.

4. Cellule photovoltaïque selon l'une des revendications 1 à 3, ***caractérisée* en ce que** la cellule photovoltaïque comprend au moins successivement :
- un substrat,
- une première électrode,
- une couche N,
- une couche active,
- une couche P,
- une deuxième électrode.

5. Cellule photovoltaïque selon l'une des revendications 1 à 4, ***caractérisée* en ce que** la couche active est en au moins un matériau semi-conducteur organique.

6. Cellule photovoltaïque selon l'une des revendications 1 à 5, ***caractérisée* en ce que** la couche active comprend un mélange contenant un matériau semi-conducteur organique de type N et un matériau semi-conducteur organique de type P.

7. Cellule photovoltaïque selon la revendication 6, ***caractérisée* en ce que** le matériau semi-conducteur de type P contenu dans la couche active est choisi parmi les polymères contenant des motifs thiophènes, les polymères contenant des motifs thiénothiophènes, les polymères contenant des motifs diketopyrrolopyrroles, les polymères contenant des motifs benzothiadiazoles, les polymères contenant des motifs thienopyrrolediones, les polymères contenant des motifs bithiophenedicarboximides et les polymères contenant des motifs carbazoles.

8. Cellule photovoltaïque selon la revendication 6 ou 7, ***caractérisée* en ce que** le matériau semi-conducteur de type N contenu dans la couche active est un matériau carboné choisi parmi les matériaux contenant au moins un motif parmi :
- pérylènes,
- fullerènes, avantageusement le fullerène C₆₀, le fullerène C₇₀, le fullerène C₈₀ ou le fullerène C₈₄,
- les nano- tubes de carbone semi-conducteurs,
- le graphène et les nanographènes,
- et leurs dérivés solubles, avantageusement le [6,6]-phényl-Cei-butyrate de méthyle ou PC₆₁BM, le [6,6]-phényl-C₇₁-butyrate de méthyle ou PC₇₁BM, un thiophène-C₆₁-butyrate de méthyle, un multi-adduit d'un fullerène C₆₀ ou C₇₀ ou des nanotubes de carbone fonctionnalisés,
- des polymères de type N.

9. Cellule photovoltaïque selon l'une des revendications 1 à 4, ***caractérisée* en ce que** la couche active est en matériau pérovskite.

10. Cellule photovoltaïque selon l'une des revendications 1 à 4, ***caractérisée* en ce que** la couche active comporte au moins un matériau pérovskite hybride organique-inorganique de formule AMeX3 dans laquelle :
- A représente au moins un ion organo-ammonium méthylamonium (MA) et/ou formamidinium (FA),
- Me représente au moins un métal parmi le plomb, l'étain, le bismuth et l'antimoine, et
- X est choisi parmi Cl, Br, I et une combinaison de ces halogénures.

11. Cellule photovoltaïque selon l'une des revendications 1 à 10, ***caractérisée* en ce que** la couche N présente une composition homogène et dense, avantageusement non mésoporeuse.

12. Cellule photovoltaïque selon l'une des revendications 1 à 11, ***caractérisée* en ce que** la couche N présente une épaisseur comprise entre 5 nanomètres et 200 nanomètres, avantageusement entre 10 nanomètres et 100 nanomètres.

13. Procédé de préparation d'une couche N, selon les étapes suivantes :
- préparation d'une encre pour couche N comprenant au moins un solvant, des particules d'oxyde métallique (np) et au moins un composé pyridinium (Pyr-X) de formule C₅H₄R₁NR₂⁺X⁻ : 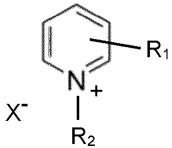
R₁ et R₂ étant indépendamment l'un de l'autre un groupement hydrocarboné en C₁-C₈,
X⁻ étant un anion,
l'encre présentant un rapport massique np/Pyr-X compris entre 97/3 et 75/25,
- dépôt de l'encre de couche N sur un substrat,
- élimination du solvant de l'encre déposée,
- formation d'une couche N.

14. Procédé de préparation d'une cellule photovoltaïque ayant une structure NIP, selon les étapes suivantes :
- formation d'une première électrode sur un substrat,
• - formation d'une couche N selon la revendication 13, sur la première électrode,
- formation d'une couche active sur la couche N,
- formation d'une couche P sur la couche active,
- formation d'une deuxième électrode sur la couche P.

15. Procédé de préparation d'une cellule photovoltaïque ayant une structure PIN, selon les étapes suivantes :
- formation d'une couche transparente conductrice sur un substrat,
- formation d'une couche P sur la couche transparente conductrice,
- formation d'une couche active sur la couche P,
• - formation d'une couche N selon la revendication 13, sur la couche active,
- formation d'une électrode sur la couche N.

## Patentansprüche

1. Photovoltaische Zelle, die nacheinander eine N-Schicht, eine aktive Schicht und eine P-Schicht umfasst,
wobei die N-Schicht Metalloxidpartikel (np) und zumindest eine Pyridiniumverbindung (Pyr-X) der Formel C₅H₄R₁NR₂⁺X⁻ umfasst: 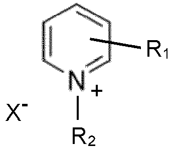
Wobei R₁ und R₂ unabhängig voneinander eine C₁-C₈ -Kohlenwasserstoffgruppe sind,
X⁻ ein Anion ist,
die Schicht N ein Massenverhältnis np/Pyr-X zwischen 97/3 und 75/25 aufweist.

2. Photovoltaische Zelle nach Anspruch 1, ***dadurch gekennzeichnet*, dass** das Anion X⁻ ein Halogen ist,
und dass R₁ und R₂ sich voneinander unterscheidende lineare C₁-C₈ -Alkylgruppen sind.

3. Photovoltaische Zelle nach Anspruch 1 oder 2, ***dadurch gekennzeichnet*, dass** die N-Schicht ein Massenverhältnis np/Pyr-X zwischen 90/10 und 80/20, vorteilhafterweise zwischen 90/10 und 85/15, aufweist.

4. Photovoltaische Zelle nach einem der Ansprüche 1 bis 3, ***dadurch gekennzeichnet*, dass** die photovoltaische Zelle nacheinander zumindest Folgendes umfasst:
- ein Substrat,
- eine erste Elektrode,
- eine N-Schicht,
- eine aktive Schicht,
- eine P-Schicht,
- eine zweite Elektrode.

5. Photovoltaische Zelle nach einem der Ansprüche 1 bis 4, ***dadurch gekennzeichnet*, dass** die aktive Schicht aus zumindest einem organischen Halbleitermaterial besteht.

6. Photovoltaische Zelle nach einem der Ansprüche 1 bis 5, ***dadurch gekennzeichnet*, dass** die aktive Schicht eine Mischung umfasst, die ein organisches Halbleitermaterial vom Typ N und ein organisches Halbleitermaterial vom Typ P umfasst.

7. Photovoltaische Zelle nach Anspruch 6, ***dadurch gekennzeichnet*, dass** das Halbleitermaterial vom P-Typ, das in der aktiven Schicht enthalten ist, ausgewählt ist aus Polymeren, die Thiopheneinheiten enthalten, Polymeren, die Thienothiopheneinheiten enthalten, Polymeren, die Diketopyrrolopyrroleinheiten enthalten, Polymeren, die Benzothiadiazoleinheiten enthalten, Polymeren, die Thienopyrroldioneinheiten enthalten, Polymeren, die Bithiophendicarboximideinheiten enthalten, und Polymeren, die Carbazoleinheiten enthalten.

8. Photovoltaische Zelle nach Anspruch 6 oder 7, ***dadurch gekennzeichnet*, dass** das Halbleitermaterial vom N-Typ, das in der aktiven Schicht enthalten ist, ein kohlenstoffhaltiges Material ist, das unter den Materialien ausgewählt ist, die zumindest eine Einheit aus den folgenden enthalten:
- Perylene,
- Fullerene, vorteilhafterweise das C₆₀ -Fulleren, das C₇₀ -Fulleren, das C₈₀ - Fulleren oder das C₈₄ -Fullerene,
- halbleitende Kohlenstoffnanoröhren,
- Graphen und Nanographene,
- und ihre löslichen Derivate, vorteilhafterweise [6,6]-Phenyl-C₆₁ - methylbutyrat oder PC₆₁BM, [6,6]-Phenyl-C₇₁ -methylbutyrat oder PC₇₁BM, ein Thiophen-C₆₁ -methylbutyrat, ein Mehrfachaddukt eines C₆₀ - oder C₇₀ - Fullerens oder funktionalisierter Kohlenstoffnanoröhren,
- Polymere vom N-Typ.

9. Photovoltaische Zelle nach einem der Ansprüche 1 bis 4, ***dadurch gekennzeichnet*, dass** die aktive Schicht aus Perowskitmaterial besteht.

10. Photovoltaische Zelle nach einem der Ansprüche 1 bis 4, ***dadurch gekennzeichnet*, dass** die aktive Schicht zumindest ein organisch-anorganisches Hybrid-Perowskitmaterial der Formel AMeX3 umfasst, worin:
- A zumindest ein Organoammonium-, Methylamonium (MA) - und/oder Formamidinium (FA) -Ion darstellt,
- Me zumindest ein Metall unter Blei, Zinn, Bismut und Antimon darstellt, und
- X aus Cl, Br, I und einer Kombination dieser Halogenide ausgewählt ist.

11. Photovoltaische Zelle nach einem der Ansprüche 1 bis 10, ***dadurch gekennzeichnet*, dass** die N-Schicht eine homogene und dichte, vorteilhafterweise nicht mesoporöse, Zusammensetzung aufweist.

12. Photovoltaische Zelle nach einem der Ansprüche 1 bis 11, ***dadurch gekennzeichnet*, dass** die N-Schicht eine Dicke zwischen 5 Nanometern und 200 Nanometern, vorteilhafterweise zwischen 10 Nanometern und 100 Nanometern, aufweist.

13. Verfahren zur Herstellung einer N-Schicht nach den folgenden Schritten:
- Herstellung einer N-Schicht-Tinte, die zumindest ein Lösungsmittel, Metalloxidpartikel (np) und zumindest eine Pyridiniumverbindung (Pyr-X) der Formel C₅H₄R₁NR₂⁺X⁻ umfasst: 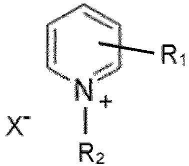
Wobei R₁ und R₂ unabhängig voneinander eine C₁-C₈ - Kohlenwasserstoffgruppe sind,
X" ein Anion ist,
die Tinte ein Massenverhältnis np/Pyr-X zwischen 97/3 und 75/25 aufweist,
- Abscheidung der N-Schicht-Tinte auf einem Substrat,
- Entfernung des Lösungsmittels aus der abgeschiedenen Tinte,
- Bildung einer N-Schicht.

14. Verfahren zur Herstellung einer photovoltaischen Zelle mit einer NIP-Struktur nach den folgenden Schritten:
- Bildung einer ersten Elektrode auf einem Substrat,
• - Bildung einer N-Schicht nach Anspruch 13 auf der ersten Elektrode,
- Bildung einer aktiven Schicht auf der N-Schicht,
- Bildung einer P-Schicht auf der aktiven Schicht,
- Bildung einer zweiten Elektrode auf der P-Schicht.

15. Verfahren zur Herstellung einer photovoltaischen Zelle mit einer PIN-Struktur nach den folgenden Schritten:
- Bilden einer leitfähigen transparenten Schicht auf einem Substrat,
- Bildung einer P-Schicht auf der leitfähigen transparenten Schicht,
- Bildung einer aktiven Schicht auf der P-Schicht,
• - Bildung einer N-Schicht nach Anspruch 13 auf der aktiven Schicht,
- Bildung einer Elektrode auf der N-Schicht.

## Claims

1. A photovoltaic cell comprising, in succession, an N-layer, an active layer and a P-layer,
the N-layer comprising particles of metal oxide (np) and at least one pyridinium compound (Pyr-X) with formula C₅H₄R₁NR₂⁺X⁻: 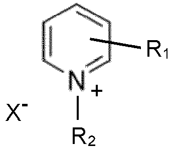
R₁ and R₂, independently of one another, being a C₁-C₈ hydrocarbon group,
X⁻ being an anion,
the N-layer having a np/Pyr-X weight ratio in the range 97/3 to 75/25.

2. The photovoltaic cell as claimed in claim 1, ***characterized* in that** the anion X⁻ is a halogen,
and **in that** R₁ and R₂ are linear C₁-C₈ alkyl groups which are distinct from one another.

3. The photovoltaic cell as claimed in claim 1 or claim 2, ***characterized* in that** the N-layer has a np/Pyr-X weight ratio in the range 90/10 to 80/20, advantageously in the range 90/10 to 85/15.

4. The photovoltaic cell as claimed in one of claims 1 to 3, ***characterized* in that** the photovoltaic cell comprises at least, in succession:
- a substrate,
- a first electrode,
- an N-layer,
- an active layer,
- a P-layer,
- a second electrode.

5. The photovoltaic cell as claimed in one of claims 1 to 4, ***characterized* in that** the active layer is produced from at least one organic semiconductor material.

6. The photovoltaic cell as claimed in one of claims 1 to 5, ***characterized* in that** the active layer comprises a mixture containing an organic N type semiconductor material and an organic P type semiconductor material.

7. The photovoltaic cell as claimed in claim 6, ***characterized* in that** the P-type semiconductor material contained in the active layer is selected from polymers containing thiophene motifs, polymers containing thienothiophene motifs, polymers containing diketopyrrolopyrrole motifs, polymers containing benzothiadiazole motifs, polymers containing thienopyrroledione motifs, polymers containing bithiophenedicarboximide motifs and polymers containing carbazole motifs.

8. The photovoltaic cell as claimed in claim 6 or claim 7, ***characterized* in that** the N-type semiconductor material contained in the active layer is a carbonaceous material selected from materials containing at least one motif selected from:
- perylenes,
- fullerenes, advantageously C₆₀ fullerene, C₇₀ fullerene, C₈₀ fullerene or C₈₄ fullerene,
- semiconductive carbon nanotubes,
- graphene and nanographenes,
- and their soluble derivatives, advantageously methyl [6,6]-phenyl-C₆₁ butyrate or PC₆₁BM, methyl [6,6]-phenyl-C₇₁ butyrate or PC₇₁BM, a methyl thiophene-C₆₁ butyrate, a multi-adduct of a C₆₀ or C₇₀ fullerene or functionalized carbon nanotubes,
- N type polymers.

9. The photovoltaic cell as claimed in one of claims 1 to 4, ***characterized* in that** the active layer is formed by a perovskite material.

10. The photovoltaic cell as claimed in one of claims 1 to 4, ***characterized* in that** the active layer comprises at least one hybrid organic-inorganic perovskite material with formula AMeX3, in which:
- A represents at least one organo-ammonium methylammonium (MA) ion and/or formamidinium (FA) ion,
- Me represents at least one metal selected from lead, tin, bismuth and antimony, and
- X is selected from Cl, Br, I and a combination of these halides.

11. The photovoltaic cell as claimed in one of claims 1 to 10, ***characterized* in that** the N-layer has a homogeneous and dense composition which is advantageously not mesoporous.

12. The photovoltaic cell as claimed in one of claims 1 to 11, ***characterized* in that** the N-layer has a thickness in the range 5 nanometres to 200 nanometres, advantageously in the range 10 nanometres to 100 nanometres.

13. A process for the preparation of an N-layer, in accordance with the following steps:
- preparing an ink for the N-layer comprising at least one solvent, particles of metal oxide (np) and at least one pyridinium compound (Pyr-X) with formula C₅H₄R₁NR₂⁺X⁻: 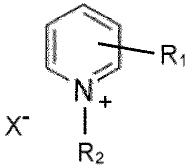
R₁ and R₂, independently of one another, being a C₁-C₈ hydrocarbon group,
X⁻ being an anion,
the ink having a np/Pyr-X weight ratio in the range 97/3 to 75/25,
- depositing the ink for the N-layer on a substrate,
- eliminating solvent from the deposited ink,
- forming an N-layer.

14. A process for the preparation of a photovoltaic cell having an NIP structure, in accordance with the following steps:
- forming a first electrode on a substrate,
• - forming an N-layer in accordance with claim 13 on the first electrode,
- forming an active layer on the N-layer,
- forming a P-layer on the active layer,
- forming a second electrode on the P-layer.

15. A process for the preparation of a photovoltaic cell having a PIN structure, in accordance with the following steps:
- forming a transparent conductive layer on a substrate,
- forming a P-layer on the transparent conductive layer,
- forming an active layer on the P-layer,
• - forming an N-layer in accordance with claim 13 on the active layer,
- forming an electrode on the N-layer.
